# EUROPÄISCHE PATENTSCHRIFT

(11) **EP 4 117 111 B1**
(45) Veröffentlichungstag und Bekanntmachung des Hinweises auf die Patenterteilung: **02.10.2024**
(21) Anmeldenummer: 22180884.3
(22) Anmeldetag: 24.06.2022
(51) Int. Cl.: H01P 1/205, H01P 1/208, H03H 7/38, H01P 5/02, H01P 5/08, H01P 5/103, H01P 5/107

(54) **HOCHFREQUENZBAUGRUPPE MIT IMPEDANZANPASSUNGSFILTER**
HIGH-FREQUENCY ASSEMBLY WITH IMPEDANCE MATCHING FILTER
MODULE HAUTE FRÉQUENCE POURVU DE FILTRE D'ADAPTATION D'IMPÉDANCE

(30) Priorität: 08.07.2021 DE 102021117730
(43) Veröffentlichungstag der Anmeldung: 11.01.2023
(73) Patentinhaber: Tesat-Spacecom GmbH & Co. KG, 71522 Backnang (DE)
(72) Erfinder: ARNOLD, Christian, 71522 Backnang (DE); FALK, Benjamin, 71522 Backnang (DE); WOCHNER, Maria, 71522 Backnang (DE); BARTZ, Sebastian, 71522 Backnang (DE); GLASBRENNER, Michael, 71522 Backnang (DE)
(74) Vertreter: LKGLOBAL Lorenz & Kopf Patentanwalt Attorney at Law PartG mbB

(56) Entgegenhaltungen:
- DE-B- 1 198 868
- JP-A- S61 208 901
- JP-B2- 6 356 490
- US-A- 3 609 571
- US-A1- 2008 042 783
- US-A1- 2009 219 107

## Beschreibung

### Technisches Gebiet

Die vorliegende Beschreibung betrifft Hochfrequenztechnik. Insbesondere betrifft die Beschreibung eine Hochfrequenzbaugruppe mit einem Impedanzanpassungsfilter, welches zwischen zwei Bauteilen mit unterschiedlicher Impedanz angeordnet ist. Weiter betrifft die Beschreibung eine Antennenanordnung mit einer oder mehreren solcher Hochfrequenzbaugruppen, wobei die Hochfrequenzbaugruppen beispielsweise als Teil einer Kommunikationseinrichtung bzw. einer Datenübertragungsstrecke, insbesondere einer Satellitenübertragungsstrecke oder einer Satellitenfunkübertragungsstrecke genutzt werden kann. Nicht zuletzt betrifft die Beschreibung einen Satelliten mit einer solchen Antennenanordnung.

### Hintergrund

Systeme aus dem Bereich der Hochfrequenztechnik werden genutzt, um Signale und Daten von einer Sendeanlage zu einer Empfangsanlage zu übertragen. Hochfrequenztechnik wird bevorzugt genutzt, wenn Daten über eine große Entfernung (bis zu mehreren Hundert oder mehreren Tausend Kilometern) übertragen werden müssen.

Bevor Signale an die Luftschnittstelle (z.B. Antenne) übergeben werden, können sie beispielsweise eine Verarbeitung, Verstärkung, oder Aufbereitung erfordern. Hochfrequenztechnik wird beispielsweise auf Kommunikationssatelliten eingesetzt, um Kommunikationssignale zu verstärken, zu kombinieren und zu filtern.

Oft besteht ein Hochfrequenzsystem aus einzelnen Modulen (rauscharme Verstärker, auch als low noise amplifier, LNA, bezeichnet, Filter, Koppler, Isolatoren, Vorverstärker, Leistungsverstärker, etc.), die miteinander verbunden sind. An der Verbindung zwischen zwei direkt miteinander verbundenen Modulen ist oftmals eine Anpassung notwendig. Üblicherweise erfolgt eine Leistungsanpassung, indem die Impedanzen der miteinander verbundenen Module aneinander angeglichen werden.

EP 2 775 612 A1 und US 9,530,604 B2 beschreiben eine Signalübertragungseinheit, welche im Hochfrequenzbereich eingesetzt wird und insbesondere Verwendung in einem Kommunikationssatelliten findet.

US 2009/219 107 A1 beschreibt ein Kopplungselement zum kommunikativen Koppeln eines Halbleiters mit einem Hohlleiter. Am Übergang zwischen Halbleiter und Hohlleiter findet sich ein gestufter Übergangsabschnitt mit mehreren Stufen. Der Querschnitt des Übergangsabschnitts verändert sich mit den Stufen. Diese Veränderung bewirkt eine Impedanzanpassung einerseits zwischen Halbleiter und Übergangsabschnitt und anderseits zwischen Übergangsabschnitt und Hohlleiter.

Ein Filter mit einem niederohmigen koaxialen Eingang und einem hochohmigen Hohlleiterausgang ist in JPS 61208901 A offenbart.

US 2008/042783 A1 offenbart eine Energieversorgungsstruktur eines Hochfrequenzverstärkers am Eingang eines Hohlraumfilters. H

### Darstellung der Erfindung

Es kann als Aufgabe betrachtet werden, die Effizienz einer Hochfrequenzbaugruppe zu verbessern.

Diese Aufgabe wird gelöst durch den Gegenstand des unabhängigen Anspruchs. Weitere Ausführungsformen ergeben sich aus den abhängigen Ansprüchen sowie aus der folgenden Beschreibung.

Gemäß der Erfindung ist eine Hochfrequenzbaugruppe, auch als HF-Baugruppe bezeichnet, angegeben. Die HF-Baugruppe weist eine Signalquelle, ein Impedanzanpassungsfilter und einen Hochfrequenzwellenleiter, auch als HF-Wellenleiter bezeichnet, auf. Die Signalquelle weist einen Halbleiter-Verstärkerausgang auf. Das Impedanzanpassungsfilter weist eine erste Schnittstelle und eine zweite Schnittstelle auf. Die erste Schnittstelle ist mit der Signalquelle kommunikativ gekoppelt, um ein Hochfrequenzsignal, HF-Signal, von der Signalquelle zu dem Impedanzanpassungsfilter übertragen zu können. Die zweite Schnittstelle ist mit dem HF-Wellenleiter kommunikativ gekoppelt, um ein HF-Signal von dem Impedanzanpassungsfilter zu dem HF-Wellenleiter übertragen zu können. Ein erster Impedanzwert an der ersten Schnittstelle entspricht einem Impedanzwert an dem Halbleiter-Verstärkerausgang (diese optimale Impedanz für den Ausgang des Halbleiterverstärkers ist in der Regel komplexwertig, besteht also aus Betrag und Phase). Ein zweiter Impedanzwert an der zweiten Schnittstelle entspricht einem Impedanzwert an dem HF-Wellenleiter. Der erste Impedanzwert und der zweite Impedanzwert haben unterschiedliche Werte. Die HF-Baugruppe weist weiterhin eine Grundplatte auf, wobei der Halbleiter-Verstärkerausgang auf der Grundplatte angeordnet ist und über eine oder mehrere Leitungen mit einem Übertragungspfad auf der Grundplatte galvanisch gekoppelt ist. Der Übertragungspfad weist ein kapazitives Kopplungselement auf, welches der ersten Schnittstelle gegenüberliegt und angeordnet ist, hochfrequente Signale kapazitiv in die erste Schnittstelle einzukoppeln. Das kapazitive Kopplungselement ist von der ersten Schnittstelle galvanisch getrennt und durch eine Lücke davon beabstandet.

In anderen Worten hat das Impedanzanpassungsfilter eingangsseitig (an der Schnittstelle zu dem Halbleiter-Verstärkerausgang) einen anderen Impedanzwert als ausgangsseitig (an der Schnittstelle zu dem HF-Wellenleiter) und ist eingangsseitig so ausgelegt, dass dem Halbleiter-Verstärkerausgang eine für den gewünschten Betriebsfall (maximale Effizienz, maximale Verstärkung, maximale Linearität, maximale Ausgangsleistung) optimale Impedanz präsentiert wird, und ist ausgangsseitig an den Hochfrequenzwellenleiter angepasst, wobei hier insbesondere von einer Leistungsanpassung für optimale Effizienz die Rede ist. Somit ist eine gesonderte Anpassungsschaltung zwischen Halbleiter-Verstärkerausgang und Hochfrequenzwellenleiter nicht mehr nötig, weil das Impedanzanpassungsfilter neben seiner Filterfunktion auch die Anpassung an die jeweils verbundenen Bauteile vornimmt. Ebenso ist ein dedizierter Hohlleiterübergang nicht mehr nötig, da das Filter über einen Hohlleiterausgang verfügt. Weiterhin kann auch auf dedizierte Block-Kondensatoren zur DC-Verblockung (zum Entfernen von DC-Anteilen aus dem HF-Signal) verzichtet werden, da das Impedanzanpassungsfilter über eine kapazitive Einkopplung verfügt.

Der Halbleiter-Verstärkerausgang ist ein Halbleiter-Baustein, beispielsweise ein Transistor, welcher ein HF-Signal ausgibt, das dem Impedanzanpassungsfilter zugeführt wird.

Das Impedanzanpassungsfilter hat zwei Funktionen. Eine erste Funktion ist, dass das Impedanzanpassungsfilter die Funktion eines Frequenzfilters erfüllt und beispielsweise als Bandpass fungiert. Eine zweite Funktion ist, dass das Impedanzanpassungsfilter an seiner ersten Schnittstelle an die Impedanz des Halbleiter-Verstärkerausgangs angepasst ist und an der zweiten Schnittstelle an die Impedanz des HF-Wellenleiters angepasst ist. Bei dieser Anpassung handelt es sich bevorzugt um eine Leistungsanpassung, d.h. dass der Impedanzwert der ersten Schnittstelle dem Impedanzwert des Verstärkerausgangs entspricht und der Impedanzwert der zweiten Schnittstelle dem Impedanzwert des HF-Wellenleiters entspricht.

Somit werden Leistungsverluste durch die benötigte Impedanzanpassung reduziert, da das Impedanzanpassungsfilter in Hohlleitertechnik erheblich geringere Verluste aufweist als beispielsweise eine auf dem Leistungsverstärkersubstrat oder einem PCB realisierte Mikrostreifen-Anpassstruktur. Weiterhin ermöglicht es dieser Aufbau der HF-Baugruppe, auf eine gesonderte Anpassungsschaltung zu verzichten. Die Anpassung erfolgt vielmehr in dem Impedanzanpassungsfilter. Die Anzahl der Bauteile wird reduziert, was sowohl den Energiebedarf als auch die thermische Last reduziert. Insgesamt wird durch den hier beschriebenen Aufbau die Leistungseffizient (als Verhältnis von Ausgangsleistung zu Eingangsleistung bezogen auf die HF-Baugruppe) verbessert. Die hierin angesprochenen Impedanzwerte sind bevorzugt komplexe Werte und beziehen sich jeweils auf Betrag und Phase an den jeweiligen Positionen in der HF-Baugruppe. Weiterhin ist das Filter so ausgelegt, dass für die mechanische Verbindung zwischen Filter und Verstärker nötige Strukturen (z.B. Drahtbonds, Mikrostreifenleitung) kompensiert werden können.

Eine kommunikative Kopplung zwischen der ersten Schnittstelle und der Signalquelle bzw. zwischen der zweiten Schnittstelle und dem HF-Wellenleiter bedeutet, dass diese beiden Kopplungen so ausgestaltet sind, dass elektrische und/oder elektromagnetische Signale übertragen werden können. Dies setzt nicht zwingend voraus, dass eine galvanische, elektrisch leitende Verbindung zwischen den genannten Komponenten besteht. Vielmehr können Signale, insbesondere hochfrequente Signale, auch über eine kapazitive Kopplung übertragen werden. Die kapazitive Kopplung erlaubt den Verzicht von dedizierten Block-Kondensatoren im HF-Pfad und verringert damit ebenso die HF-Verluste um den durch den von den Kondensatoren hervorgerufenen Anteil.

Gemäß einer Ausführungsform weist der Halbleiter-Verstärkerausgang einen niedrigeren Impedanzwert aufweist als der HF-Wellenleiter.

Halbleiter-Verstärkerausgänge, beispielsweise in Form von Transistoren, haben typischerweise einen reellen Impedanzwert zwischen 10 und 30 Ohm. HF-Wellenleiter in Form von Koaxialleitungen oder Hohlleitern haben dagegen typischerweise einen reellen Impedanzwert von etwa 50 Ohm und mehr.

Das Impedanzanpassungsfilter leistet eine Anpassung zwischen diesen Bauteilen mit ihren unterschiedlichen Impedanzwerten.

Gemäß einer weiteren Ausführungsform ist das Impedanzanpassungsfilter als Hohlleiter mit mindestens einem Resonator und/oder mindestens einem Fenster ausgestaltet ist.

Das Impedanzanpassungsfilter ist bevorzugt in Hohlleitertechnik ausgestaltet. Daher zeichnet es sich durch eine hohe Effizienz bzw. niedrige Verluste aus, wodurch die Leistungseffizienz der HF-Baugruppe insgesamt besser wird.

Bei den Resonatoren und/oder Fenstern handelt es sich um Bestandteile des Impedanzanpassungsfilters, welche durch ihren Aufbau und ihre Gestalt Einfluss auf die Filterfunktion und den Wellenwiderstand des Impedanzanpassungsfilters ausüben.

Gemäß einer weiteren Ausführungsform weist das Impedanzanpassungsfilter mehrere Resonatoren und/oder mehrere Fenster auf, die entlang einer Signalausbreitungsrichtung in dem Impedanzanpassungsfilter hintereinander angeordnet sind.

Die mehreren hintereinander angeordneten und voneinander beabstandeten Resonatoren und/oder Fenster sorgen für eine Anpassung der Impedanz des Impedanzanpassungsfilters und dienen auch dazu, die Filterfunktion zu implementieren.

Bevorzugt ist jeweils zwischen zwei hintereinander angeordneten Resonatoren ein Fenster angeordnet, wobei ein Fenster einer Querschnittseinschnürung des Impedanzanpassungsfilters entspricht.

Gemäß einer weiteren Ausführungsform unterscheiden sich die mehreren entlang der Signalausbreitungsrichtung hintereinander angeordneten Resonatoren in ihrer Geometrie entlang der Signalausbreitungsrichtung voneinander.

Dies bedeutet, dass die Resonatoren unterschiedliche Ausmaße und/oder Formen haben. Beispielsweise können nacheinander angeordnete Resonatoren verschiedene Höhen, Materialstärken und/oder Formen aufweisen. Hierdurch erfolgt die Anpassung an die Impedanzwerte des Verstärkerausgangs einerseits und des HF-Wellenleiters andererseits.

Die Resonatoren sind so ausgestaltet, dass mindestens zwei Resonatoren unterschiedliche Geometrien aufweisen. Es ist aber auch denkbar, dass jeder Resonator eine in dem Impedanzanpassungsfilter nur einmal vorkommende Geometrie (Dimension, Form, etc.) aufweist.

Gemäß einer weiteren Ausführungsform ist das Impedanzanpassungsfilter als Hohlleiter mit oder ohne einen Steg ausgestaltet.

Gemäß einer weiteren Ausführungsform weist der eine Steg mehrere Stegabschnitte auf, wobei die Stegabschnitte unterschiedliche Geometrien aufweisen.

Die Stegabschnitte sind in Signalausbreitungsrichtung hintereinander angeordnet. Insbesondere sind die Stege unmittelbar aneinander grenzend angeordnet. Die Stegabschnitte haben beispielsweise eine unterschiedliche Höhe und/oder Breite. Die mehreren hintereinander angeordneten und unterschiedlich ausgestalteten Stegabschnitte sorgen für eine Anpassung der Impedanz des Impedanzanpassungsfilters, weil die unterschiedlich ausgestalteten Stegabschnitte unterschiedliche Wellenwiderstände haben.

Gemäß der Erfindung weist die HF-Baugruppe weiterhin eine Grundplatte auf, wobei der Halbleiter-Verstärkerausgang auf der Grundplatte angeordnet ist und über eine oder mehrere Leitungen mit einem Übertragungspfad auf der Grundplatte galvanisch gekoppelt ist. Der Übertragungspfad weist ein kapazitives Kopplungselement auf, welches der ersten Schnittstelle gegenüberliegt und angeordnet ist, hochfrequente Signale kapazitiv in die erste Schnittstelle einzukoppeln.

Das kapazitive Kopplungselement ist von der ersten Schnittstelle galvanisch getrennt und durch eine Lücke davon beabstandet. Hochfrequente Signale in einem Frequenzbereich von mehreren GHz werden von dem Halbleiter-Verstärkerausgang in den Übertragungspfad und das kapazitive Kopplungselement gespeist. Auf Grund der hohen Frequenzen werden diese Signale kapazitiv, also ohne galvanische Verbindung, von dem kapazitiven Kopplungselement in die erste Schnittstelle des Impedanzanpassungsfilters eingespeist.

Weil der Halbleiter-Verstärkerausgang galvanisch von dem Impedanzanpassungsfilter getrennt ist, wird verhindert, dass ein Gleichstromanteil des HF-Signals bzw. ein Gleichstrom, der an dem Übertragungspfad und/oder dem Kopplungselement anliegt, von dem Übertragungspfad oder von dem kapazitiven Kopplungselement auf das Impedanzanpassungsfilter übertragen wird.

Die Grundplatte ist üblicherweise eine Platine bzw. ein PCB (engl.: printed circuit board).

Gemäß einer weiteren Ausführungsform weist die HF-Baugruppe weiterhin eine Leistungsquelle auf, welche galvanisch mit dem Übertragungspfad gekoppelt ist und ausgeführt ist, eine Energieversorgung in Form von Gleichstrom, DC, auf den Übertragungspfad zu geben und über die eine oder mehreren Leitungen an den Halbleiter-Verstärkerausgang bereitzustellen.

Die DC-Leistung wird von dem Halbleiter-Verstärkerausgang, beispielsweise dem Transistor, als Betriebsenergie aufgenommen. Hierbei handelt es sich um Gleichstrom. Der Gleichstrom wird über denselben Übertragungspfad übertragen wie das HF-Signal.

Gemäß einer weiteren Ausführungsform weist die Leistungsquelle ein DC-Filter auf, welches ausgestaltet ist, für hochfrequente Signale auf dem Übertragungspfad undurchlässig zu sein.

Das DC-Filter ist beispielsweise als Tiefpass ausgestaltet. Somit lässt das DC-Filter Gleichstromsignale passieren und ist für hochfrequente Signale undurchlässig. Für die HF-Signale auf dem Übertragungspfad, also die von dem Halbleiter-Verstärkerausgang ausgegebenen Nutzsignale, ist das DC-Filter undurchlässig, so dass die DC-Energieversorgung auf den Impedanzwert des Halbleiter-Verstärkerausgang und das Verhalten gegenüber hochfrequenten Signalen ohne nennenswerten Einfluss ist.

Gemäß einer weiteren Ausführungsform weist die HF-Baugruppe eine Mehrzahl von Halbleiter-Verstärkerausgängen auf, welche mit der ersten Schnittstelle des Impedanzanpassungsfilters kapazitiv gekoppelt sind.

In dieser Ausführungsform werden mehrere Halbleiter-Verstärkerausgänge auf ein Impedanzanpassungsfilter gekoppelt. Damit wird die in das Impedanzanpassungsfilter eingespeiste Leistung vervielfacht. In dieser Variante erfolgt eine Kombination bzw. eine Vervielfachung der Leistung auf der Eingangsseite des Impedanzanpassungsfilters.

Gemäß einer weiteren Ausführungsform weist die HF-Baugruppe eine Mehrzahl von Impedanzanpassungsfiltern auf, wovon jedes mit mindestens einem Halbleiter-Verstärkerausgang gekoppelt ist, wobei die Mehrzahl von Impedanzanpassungsfiltern mit einem einzelnen HF-Wellenleiter gekoppelt sind.

Alternativ oder zusätzlich zu der vorherigen Ausführungsform erfolgt in dieser Ausführungsform eine Leistungskombination auf der Ausgangsseite des Impedanzanpassungsfilters. Auch diese Ausführungsform dient dazu, die ausgegebene Leistung zu vervielfachen. Die mehreren Impedanzanpassungsfilter sind ausgangsseitig, also an ihrer jeweiligen zweiten Schnittstelle, mit demselben HF-Wellenleiter verbunden. Es ist denkbar, dass die jeweiligen zweiten Schnittstellen zunächst miteinander verbunden werden und dann ein gemeinsamer Ausgang der Mehrzahl von Impedanzanpassungsfiltern auf einen einzelnen HF-Wellenleiter geführt wird. Alternativ sind die jeweiligen zweiten Schnittstellen individuell mit dem HF-Wellenleiter gekoppelt. Zwei oder mehrere Impedanzanpassungsfilter können ausgangsseitig mit einem sog. 3dB-Koppler gekoppelt und auf den HF-Wellenleiter geführt sein.

Gemäß einer weiteren Ausführungsform ist der HF-Wellenleiter ein Hohlleiter, ein Steghohlleiter, oder ein Koaxialleiter.

Gemäß einem weiteren Aspekt ist eine Antennenanordnung angegeben. Die Antennenanordnung weist eine Antenne und eine Mehrzahl von HF-Baugruppen wie hierin beschrieben auf. Die mehreren HF-Baugruppen sind mit der Antenne verbunden, um ein Nutzsignal an die Antenne zu übertragen.

Gemäß einem weiteren Aspekt ist ein Kommunikationssatellit angegeben, der eine Antennenanordnung wie hierin beschrieben aufweist.

Die Antennenanordnung ist beispielsweise Bestandteil einer Datenübertragungsstrecke in dem Kommunikationssatelliten. Ein Kommunikationssatellit ist ein für die Verwendung im Erdorbit vorgesehenes Raumfahrzeug, welches eine Kommunikationsanlage zum Empfangen und Senden von Daten bzw. Signalen enthält. Daneben kann ein Kommunikationssatellit auch Einheiten zum Verarbeiten der Daten enthalten. Die HF-Baugruppe kann bevorzugt in einem Signalverarbeitungspfad der Kommunikationsanlage des Kommunikationssatelliten verwendet werden.

Im Zusammenhang dieser Beschreibung, also bezogen auf die HF-Baugruppe, die Antennenanordnung und den Kommunikationssatelliten, ist unter Hochfrequenz ein Frequenzbereich oberhalb von einem GHz (Gigahertz, 1 x 10E9 Hertz) zu verstehen. Solche Frequenzbereiche werden beispielsweise bei Satellitenfunkübertragungsstrecken genutzt. Bei einer solchen Satellitenfunkübertragungsstrecke kann es sich beispielsweise um eine Ka-Band Übertragungsstrecke handeln in einem Frequenzbereich von 17,7 - 21,2 GHz für die Abwärtsstrecke (downlink) und 27,5 - 31 GHz für die Aufwärtsstrecke (uplink), um eine Ku- oder X-Band-Implementierung im Bereich um 11 bzw. 7 GHz, oder um eine L-Band- (um 1,5 GHz), S-Band- (um 2,5 GHz) oder C-Band-Implementierung (um 4 GHz).

Der Halbleiter-Verstärkerausgang kann ein Bauteil eines Verstärkers sein, welcher der Antenne vorgeschaltet ist. Als Verstärker kann beispielsweise ein Hochleistungs-Transistorverstärker verwendet werden. Ein Hochleistungs-Transistorverstärker kann auch als solid-state power amplifier (SSPA) bezeichnet werden. Dieser Art Verstärker wird bei hohen Frequenzen alternativ oder zusätzlich zu sog. Wanderfeldröhrenverstärkern genutzt. SSPAs sind in verschiedenen Leistungsklassen und für sehr hohe Frequenzbänder verfügbar. Beispielsweise können SSPAs in den folgenden Frequenzbändern genutzt werden: C-, X-, Ku-, Ka- und Q-Band.

### Kurze Beschreibung der Figuren

Nachfolgend wird anhand der beigefügten Zeichnungen näher auf Ausführungsbeispiele der Erfindung eingegangen. Die Darstellungen sind schematisch und nicht maßstabsgetreu. Gleiche Bezugszeichen beziehen sich auf gleiche oder ähnliche Elemente. Es zeigen:
- Fig. 1: eine schematische Darstellung einer HF-Baugruppe mit einer kapazitiven Kopplung.
- Fig. 2: eine schematische Darstellung eines Teils einer HF-Baugruppe.
- Fig. 3: eine schematische Darstellung der Verbindung zwischen einem HF-Verstärkerausgang und einem Impedanzanpassungsfilter.
- Fig. 4: eine schematische Darstellung der Verbindung zwischen einem HF-Verstärkerausgang und einem Impedanzanpassungsfilter.
- Fig. 5: eine schematische Darstellung einer Verbindung zwischen einem HF-Verstärkerausgang und einem Impedanzanpassungsfilter mit mehreren Zweigen.
- Fig. 6: eine schematische isometrische Darstellung der Verbindung zwischen einem HF-Verstärkerausgang und einem Impedanzanpassungsfilter mit mehreren Resonatoren.
- Fig. 7: eine schematische Darstellung eines Satelliten mit einer HF-Baugruppe und einer Antenne.
- Fig. 8: eine schematische Darstellung HF-Baugruppe mit einem Impedanzanpassungsfilter in Form eines Steghohlleiters mit mehreren Stegabschnitten.
- Fig. 9: eine schematische Darstellung einer Antennenanordnung.

### Detaillierte Beschreibung von Ausführungsbeispielen

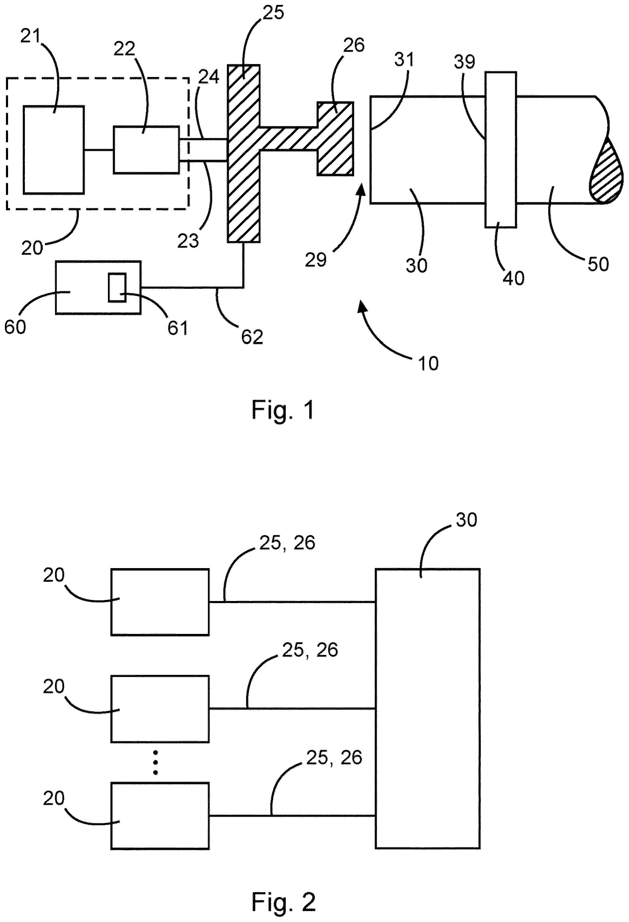

Fig. 1 zeigt eine schematische Darstellung einer HF-Baugruppe 10. Die HF-Baugruppe 10 weist eine Signalquelle 20 auf. Die Signalquelle 20 gibt ein Signal aus, welches einem Signalübertragungspfad folgt. Der Signalübertragungspfad verläuft in der Darstellung der Fig. 1 von links nach rechts. Dabei wird ein HF-Signal zunächst von der Signalquelle 20 über die erste Leitung 23 und die zweite Leitung 24 auf den Übertragungspfad 25 und das kapazitive Kopplungselement 26 ausgegeben. Von dem kapazitiven Kopplungselement 26 wird das HF-Signal kapazitiv, also leitungslos, in die erste Schnittstelle 31 des Impedanzanpassungsfilters 31 gespeist. Zwischen dem kapazitiven Kopplungselement 26 und der ersten Schnittstellen 31 ist eine Lücke 29 angeordnet. Das HF-Signal breitet sich über das Impedanzanpassungsfilter 30 zu der zweiten Schnittstelle 39 aus, von wo aus das HF-Signal in den HF-Wellenleiter 50 eingespeist wird.

Eine Leistungsquelle 60, beispielsweise in Form einer Gleichstromversorgung, ist über eine Anschlussleitung 62 mit dem Übertragungspfad 25 verbunden. Eine Gleichstrom-Energieversorgung wird von der Leistungsquelle 60 auf den Übertragungspfad 25 und von dort über die erste Leitung 23 und die zweite Leitung 24 an den Halbleiter-Verstärkerausgang 22 gegeben. Somit wird über die erste Leitung 23 und die zweite Leitung 24 sowohl ein HF-Signal als auch die Energieversorgung für den Halbleiter-Verstärkerausgang 22 übertragen. Die Leistungsquelle 60 weist auch ein Gleichstromfilter (DC-Filter) 61 auf. Das Gleichstromfilter 61 hat die Funktion, Gleichstrom passieren zu lassen und hochfrequente Signale nicht passieren zu lassen bzw. stark zu dämpfen.

Die Signalquelle 20 ist beispielsweise ein Leistungsverstärker und besteht aus einer Verstärkereinheit 21 und einem Halbleiter-Verstärkerausgang 22. Der Halbleiter-Verstärkerausgang 22 ist beispielsweise ein Transistor, welcher ein von der Verstärkereinheit 21 verstärktes Signal ausgibt. Insofern kann der Halbleiter-Verstärkerausgang 22 in die Verstärkereinheit 21 integriert oder gesondert davon bereitgestellt sein.

Die Signalquelle 20 ist in diesem Beispiel ein Hochfrequenz-Leistungsverstärkermodul. Hochfrequenz-Leistungsverstärkermodule werden in der Satellitenkommunikation häufig eingesetzt. Sie werden verwendet, um ein Sendesignal auf das erforderliche Leistungsniveau zu bringen, um an einer Gegenstelle, z.B. auf der Erde, noch empfangsfähige Signalpegel zu erreichen. Historisch gesehen kamen hierfür - insbesondere bei höheren Frequenzen über 6 GHz - Vakuumröhrenverstärker zum Einsatz. Diese haben hervorragende Eigenschaften, insbesondere hohe Effizienz (gemessen an einem geringem DC-Energieverbrauch für die verfügbare HF-Ausgangsleistung) bei guter Linearität (geringe Verzerrung des Signals). Insbesondere für den Einsatz in sog. aktiven Antennen, also elektronisch steuerbaren Antennen, haben halbleiterbasierte Verstärker jedoch große Vorteile, insbesondere bezüglich Abmessungen und Kosten. Bei einer aktiven Antenne werden eine große Anzahl von Verstärkern mit eher geringer Leistung benötigt, da jedes Antennenelement einen eigenen Verstärker benötigt. Jedoch wird auch eine hohe Linearität mit sehr hoher Leistungseffizienz benötig. Hier haben klassische halbleiterbasierte Verstärker in der Regel jedoch einige Defizite. Dies führt nicht nur zu einem hohen Energieverbrauch, sondern auch zu hoher Wärmeentwicklung. Dies kann die thermische Auslegung der Antenne erschweren bzw. sogar unmöglich machen. Diese Nachteile werden durch den hier vorgeschlagenen Aufbau der HF-Baugruppe für Anwendung in aktiven Antennen überwunden. Selbstverständlich sind auch für andere Verstärkeranwendungen hohe Effizienz wünschenswert, die vorliegende HF-Baugruppe kann ohne weiteres auch für andere Leistungsverstärkeranwendungen verwendet werden (z.B. Gateway-Verstärker, Kanalverstärker etc.).

In der Verstärkereinheit 21 und dem Halbleiter-Verstärkerausgang 22 der Signalquelle 20 können integrierte Bausteine in GaN- oder GaAs-Technologie zum Einsatz kommen.

Die hier beschriebene HF-Baugruppe kann beispielsweise in einem aktiven Antennenmodul mit einer Bandbreite von 17,8 - 20,2 GHz (im Ka-Band) verwendet werden. Jedoch ist ein Transfer zu anderen Verstärkeranwendungen und Frequenzen problemlos möglich (z.B. Ku-Band 10,7 - 12,7 GHz, Q-Band 37,5 - 42,5 GHz), sofern geeignete Transistoren zur Verfügung stehen. Die HF-Baugruppe kann so ausgestaltet sein, dass sie eine Linearitätsforderung (gegeben durch 17dB NPR - noise power ratio) und eine Effizienzforderung > 30 % (für die Endstufe, gegeben durch eine max. Antennengesamtleistung von ca. 600 W für mehrere Verstärkerpfade) bei gegebenen Abmessungen von ca. 7×3mm^2 für einen einzelnen Verstärkerkanal erfüllt.

Die Signalquelle 20 ist mittels zweier Leitungen 23, 24 mit einem Übertragungspfad 25 verbunden, so dass elektromagnetische Signale induktiv von dem Verstärkerausgang 22 auf den Übertragungspfad 25 übertragen werden können. Der Übertragungspfad 25 ist beispielsweise eine Leiterbahn auf einer Platine. Der Übertragungspfad 25 geht in ein kapazitives Kopplungselement 26 über. Das kapazitive Kopplungselement 26 ist beispielsweise unmittelbar mit dem Übertragungspfad 25 verbunden bzw. diese beiden Elemente sind Teil derselben Leiterbahn auf der Platine.

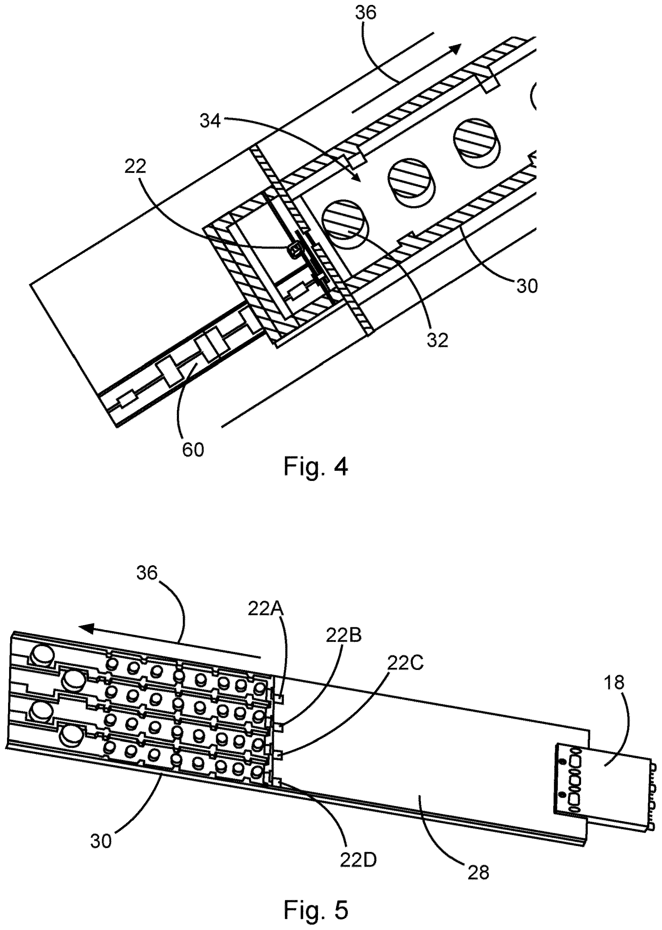

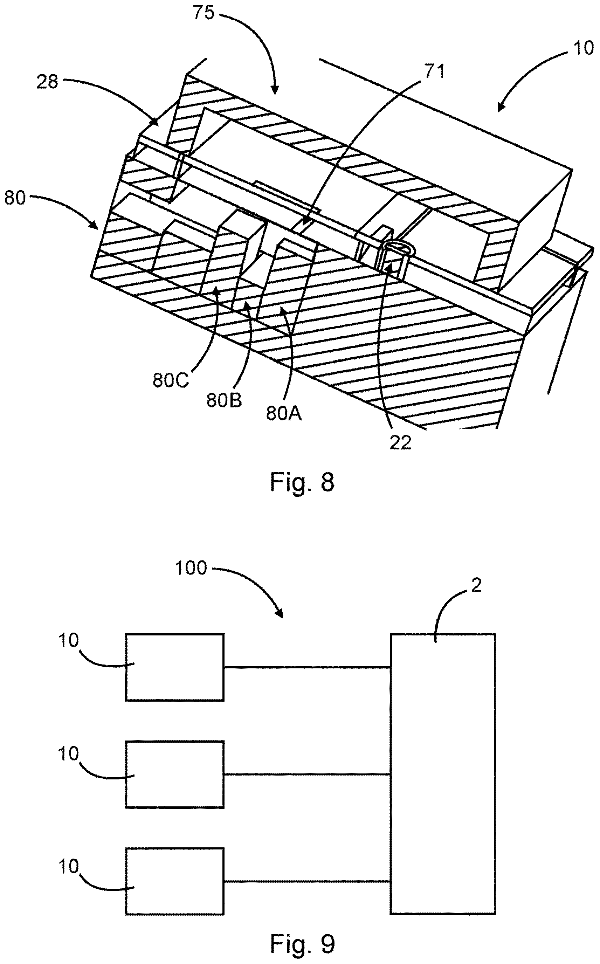

Als Halbleiter für den Verstärkerausgang 22 kommt ein Einzeltransistor in GaN (oder GaAs) Technologie zum Einsatz, und zwar ohne integriertes Anpassungs- und Stabilisierungsnetzwerk. Insbesondere die Anpassung am Ausgang des Transistors wird über eine Hohlleiterstruktur (nämlich das Impedanzanpassungsfilter 30) hergestellt. Hier sind zwei Varianten denkbar. Eine erste Variante ist in den Fig. 4 bis 6 mit einem Filter mit Resonatoren und Fenstern dargestellt und eine zweite Variante ist in Fig. 8 mit einem Steghohlleiter gezeigt.

Die Einkopplung in die Hohlleiterstruktur des Impedanzanpassungsfilters erfolgt möglichst direkt. Denkbar ist hierfür ein kurzes Stück PCB/Keramiksubtrat aber auch eine koaxiale Struktur. Die Gleichstromversorgung des als Verstärkerausgang fungierenden Transistors wird entweder über ein Filter zugeführt, wobei eine sonst übliche Verblockung mit Kapazitäten an den Eingang des Filters verlegt werden kann oder) oder wird mit Kondensatoren gesperrt.

Somit ist auf der HF-Leitung (erste Leitung 23, zweite Leitung 24) eine weitere Gleichstromsperre nicht mehr nötig, da die Einkopplung des HF-Signals in die Hohlleiterstruktur des Impedanzanpassungsfilters kapazitiv erfolgt.

Das Impedanzanpassungsfilter 30 ist mittels einer Kopplungseinheit 40 mit dem HF-Wellenleiter 50 gekoppelt. Die Kopplungseinheit 40 kann beispielsweise ein Flansch oder eine andere Verbindung sein.

Das Impedanzanpassungsfilter 30 ist in Hohlleitertechnik gefertigt und hat die Funktion, von dem Verstärkerausgang 22 ausgegebene Signale zu filtern und eine Anpassung an den Verstärkerausgang 22 einerseits sowie eine Anpassung an den HF-Wellenleiter 50 andererseits vorzunehmen. Durch diesen Aufbau wird die Anzahl der für eine Anpassungsschaltung benötigten Bauteile reduziert, was die Effizienz der HF-Baugruppe 10 verbessert und eine hohe Linearität bereitstellt. Insbesondere kann auf ein sonst bei Halbleiterverstärkern üblicherweise verwendetes Anpassungsnetzwerk am Ausgang des Verstärkers verzichtet werden. Solch ein Anpassungsnetzwerk führt üblicherweise zu hohen Verlusten, was die Effizienz des Verstärkers reduziert.

Diese Nachteile werden dadurch vermieden, dass das Impedanzanpassungsfilter 30 in Hohlleitertechnik ausgestaltet ist und ein kapazitiver Übergang als Sperre für Gleichstromanteile zwischen dem Verstärkerausgang und dem Impedanzanpassungsfilter verwendet wird.

Fig. 2 zeigt eine beispielhafte Verbindung von mehreren Signalquellen 20 mit einem einzelnen Impedanzanpassungsfilter 30. Eine beliebige Anzahl von Signalquellen (vorgegeben durch den verfügbaren Bauraum und die Anforderungen an den Pegel des Signals) kann mit dem Impedanzanpassungsfilter verbunden werden, wobei die Verbindung zwischen den Signalquellen 20 und dem Impedanzanpassungsfilter 30 so ausgestaltet ist, wie in Fig. 1 mit Bezug auf den Übertragungspfad 25 und das kapazitive Kopplungselement 26 ausgestaltet ist.

Die Schaltung der Fig. 2 dient dazu, höhere Leistungspegel zu erreichen. Es ist aber auch denkbar, dass mehrere Impedanzanpassungsfilter 30 ausgangsseitig miteinander verbunden werden, um den ausgegebenen Leistungspegel zu erhöhen.

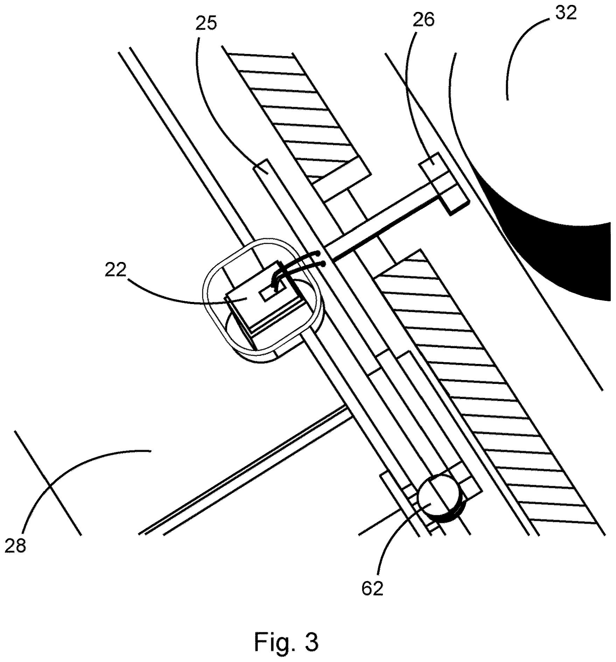

Fig. 3 zeigt eine Detailansicht des Halbleiter-Verstärkerausgangs 22, welcher mittels zweier Leitungen mit dem Übertragungspfad 25 verbunden ist. Das Halbleiter-Verstärkerausgang 22 ist auf einer Grundplatte 28 angeordnet. Eine Anschlussleitung 62 für die Gleichstromversorgung des Halbleiter-Verstärkerausgangs 22 ist mit dem Übertragungspfad 25 verbunden. Der Übertragungspfad 25 geht über in das kapazitive Kopplungselement 26. Ein HF-Signal wird von dem Halbleiter-Verstärkerausgang 22 auf den Übertragungspfad 25 ausgegeben, breitet sich dann darauf in Richtung des kapazitiven Kopplungselements 26 aus, von wo das HF-Signal kapazitiv in das Impedanzanpassungsfilter eingespeist wird. Von dem Impedanzanpassungsfilter ist in Fig. 3 lediglich ein Resonator 32 gezeigt. Zwischen dem Resonator 32 und dem kapazitiven Kopplungselement 26 ist eine Lücke 29 erkennbar.

Die Gleichstromversorgung für den Halbleiter-Verstärkerausgang 22 wird dem entsprechenden Transistor als Drain-Spannung zugeführt und erfolgt beispielsweise über ein PCB-integriertes Filter, in Kombination mit diskreten Kapazitäten. Alternativ kann das Filter auch durch eine Lambda/4 Leitung mit paralleler Kapazität realisiert werden. Die Drain-Spannung ist im vorliegenden Fall an den Übertragungspfad 25 angeschlossen und kann auch an jeden anderen Bereich der Leitung zum Filter angeschlossen werden.

Fig. 4 zeigt einen größeren Abschnitt einer HF-Baugruppe, wobei die in Fig. 4 gezeigte HF-Baugruppe in ihrem Aufbau der HF-Baugruppe aus Fig. 3 entspricht.

Fig. 4 zeigt eine Leistungsquelle 60, welche dem Halbleiter-Verstärkerausgang 22 elektrische Energie zur Verfügung stellt. Der Halbleiter-Verstärkerausgang 22 gibt über den Übertragungspfad und das kapazitive Kopplungselement ein HF-Signal aus, welches sich entlang der Signalausbreitungsrichtung 36 in dem Impedanzanpassungsfilter 30 ausbreitet. Das Impedanzanpassungsfilter 30 weist mehrere in Signalausbreitungsrichtung 36 hintereinander angeordnete Resonatoren 32 (im Beispiel der Fig. 4 sind dies zylinderförmige Sockel) und Fenster 34 (Querschnittseinschnürungen) zwischen den Resonatoren auf.

In der in Fig. 3 und 4 gezeigten Variante wird die Anpassung über eine Hohlraum-Filterstruktur in dem als Hohlleiter ausgestalteten Impedanzanpassungsfilter erzeugt. Hierfür kommen grundsätzlich alle bekannten Filtertopologien und Filtertypen in Frage (Rechteck/Rund-Hohlleiterfilter, Koax-Filter, Dielektrische Filter). Beispielhaft wird ein vier-kreisiges Koax-Filter gezeigt.

Das Impedanzanpassungsfilter 30 wird im Entwicklungsprozess so verstimmt, dass es an der ersten Schnittstelle 31 zum Transistor des Halbleiter-Verstärkerausgangs 22 nach Betrag und Phase die gewünschte Anpassung bietet. Die Anpassung kann beispielsweise durch eine sog. Load-Pull Messung oder Simulation ermittelt werden). Das Impedanzanpassungsfilter ist somit als Einzelfilter nicht verwendbar, wird es jedoch am Ausgang des Transistors des Halbleiter-Verstärkerausgangs 22 betrieben, erlaubt es, diesen in seinem optimalen Betriebspunkt (z.B. beste Effizienz bezogen auf die Leistungsanpassung) zu betreiben. Neben der Erzeugung der erforderlichen Anpassung für den Halbleiter-Verstärkerausgang hat das Impedanzanpassungsfilter 30 in Kombination mit dem Transistor des Halbleiter-Verstärkerausgangs 22 auch frequenzselektive Wirkung. Ein dediziertes Ausgangsfilter kann entfallen. Dies verbessert wiederum die Effizienz, da keine zusätzlichen Filterverluste berücksichtig werden müssen. Die Anzahl der Kreise und die Topologie des Impedanzanpassungsfilters hängt dann von den Anforderungen an das Ausgangsfilter ab, es können Filter mit und ohne Transmissionsnullstellen und mit und ohne Gruppenlaufzeitentzerrung zum Einsatz kommen, typische Kreiszahlen sind 1-Kreis bis 14-Kreis oder mehr (in praktischer Anwendung eher 4-Kreis bis 12-Kreis). Die Einkopplung des HF-Signals in das Impedanzanpassungsfilter erfolgt kapazitiv über PCB, Keramik oder Koax-Struktur (beispielsweise durch einen diskret gefertigten Innenleiter mit Isolatormaterial). PCB oder Keramik haben den Vorteil einer einfacheren und kostengünstigen Fertigung, die Koax-Struktur liefert die beste Effizienz (niedrige Verluste).

Die Verbindung des Transistors des Halbleiter-Verstärkerausgangs mit der Einkoppelstruktur ins Impedanzanpassungsfilter wird im gezeigten Beispiel mit Bonddrähten (erste Leitung 23, zweite Leitung 24, siehe Fig. 3) hergestellt. Der Transistor des Halbleiter-Verstärkerausgangs kann in einer Aussparung des PCB direkt auf dem Gehäuse oder einem Abstandshalter sitzen, aber auch direkt auf der PCB oder einer Keramik. Der Transistor kann (leitfähig) geklebt oder gelötet werden, ebenfalls ist Silbersintern oder ähnliche Verbindungstechniken denkbar.

Fig. 5 zeigt eine HF-Baugruppe mit mehreren Pfaden oder Zweigen. Über eine Eingangsschnittstelle 18 wird ein Signal auf die Grundplatte 28 gegeben. Dort erfolgt eine Verarbeitung und/oder Verstärkung des Signals. Die Mehrzahl von Impedanzanpassungsfiltern 22A, 22B, 22C, 22D gibt jeweils ein Signal auf einen Pfad des Impedanzanpassungsfilters 30 aus.

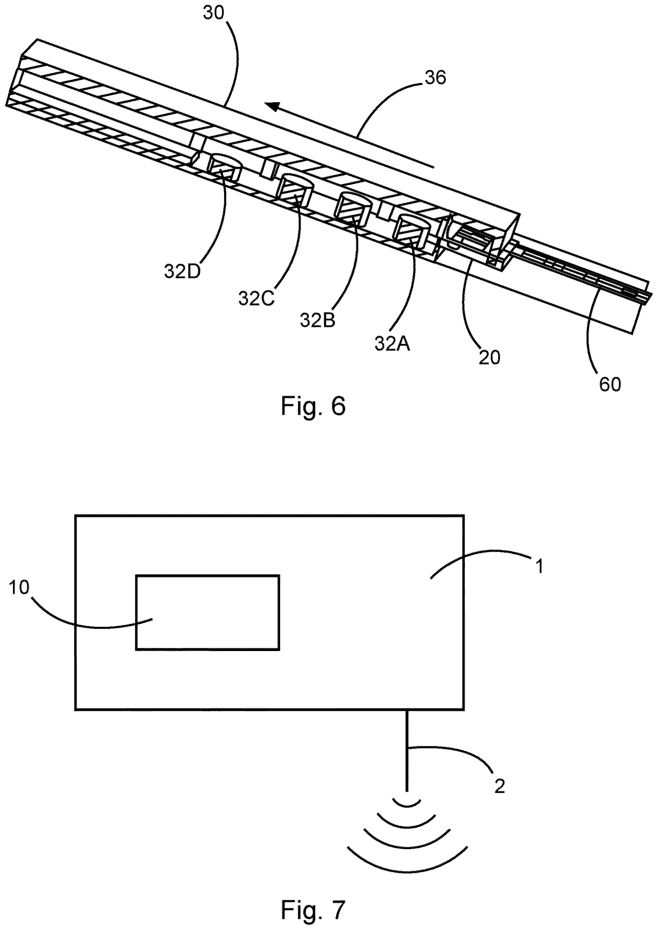

Fig. 6 zeigt eine Querschnittdarstellung eines einzelnen Pfads aus Fig. 5. Gezeigt sind die Leistungsquelle 60, die Signalquelle 20 und ein Impedanzanpassungsfilter 30 mitsamt der Signalausbreitungsrichtung 36. In dem Impedanzanpassungsfilter 30 sind vier Resonatoren 32A, 32B, 32C, 32D in Signalausbreitungsrichtung 36 hintereinander und voneinander beabstandet angeordnet. Es ist erkennbar, dass die Resonatoren eine unterschiedliche Höhe haben. Neben einer unterschiedlichen Höhe können die Resonatoren aber auch in anderen Eigenschaften voneinander abweichen, z.B. Form, Durchmesser, etc. Diese Abweichung dient dazu, eine gezielte Verstimmung des Impedanzanpassungsfilters zu erreichen, damit die eingangsseitige Impedanz und die ausgangsseitige Impedanz voneinander abweichen und eingangsseitig an den Halbleiter-Verstärkerausgang sowie ausgangsseitig an den HF-Wellenleiter leistungsangepasst ist.

Fig. 7 zeigt eine schematische Darstellung eines Kommunikationssatelliten 1. In dem Kommunikationssatelliten 1 ist eine Hochfrequenzbaugruppe 10 angeordnet. Die Hochfrequenzbaugruppe 10 kann Bestandteil eines Signalübertragungspfads in dem Kommunikationssatelliten sein. Beispielsweise kann die Hochfrequenzbaugruppe 10 ein Signal an eine Übertragungseinheit 2 in Form einer Antenne ausgeben.

Die hierin beschriebene Hochfrequenzbaugruppe eignet sich insbesondere für die signaltechnische Anbindung von Transistorverstärkern oder allgemein Halbleiterverstärkern (SSPA) an eine Antenne.

Fig. 8 zeigt eine HF-Baugruppe 10 mit einem Impedanzanpassungsfilter in Steghohlleitertechnik. Für den allgemeinen Aufbau und Funktion der HF-Baugruppe 10 wird auf die Beschreibung der obigen Figuren 1 bis 7 verwiesen.

In der Variante Fig. 8 nutzt das Impedanzanpassungsfilter einen Hohlleiter mit einem Steg 80 zur Anpassung. Der Steg 80 ist in mehrere Stegabschnitte 80A, 80B, 80C, 80D unterteilt. Der Steg 80 ist in den Stegabschnitten unterschiedlich ausgestaltet. Dies entspricht aus einer funktionalen Perspektive den unterschiedlich ausgestalteten Resonatoren, wie sie beispielsweise in Fig. 6 gezeigt sind.

Die Grundplatte 28 trägt den Halbleiter-Verstärkerausgang 22 und ist mit einer Abdeckung 75 abgedeckt.

In der Variante der Fig. 8 erfolgt die Zuführung von Gleichstrom für den Betrieb des Halbleiter-Verstärkerausgangs und die kapazitive Kopplung zu dem Impedanzanpassungsfilter wie bisher beschrieben. Das HF-Signal koppelt über eine Schlitz 71 im PCB in den Steghohlleiter des Impedanzanpassungsfilters ein, dort sind Stegabschnitte mit mehreren voneinander verschieden ausgestalteten Stufen angeordnet (entsprechend Leitungsabschnitte mit unterschiedlichen Wellenwiderständen) und sorgen für die entsprechende Anpassung der eingangsseitigen und ausgangsseitigen Impedanz des Impedanzanpassungsfilters.

Abschließend zeigt Fig. 9 eine Antennenanordnung 100 mit mehreren HF-Baugruppen 10, die mit einer Antenne 2 verbunden sind. Diese Antennenanordnung 100 kann beispielsweise in Kommunikationssatelliten verwendet werden.

### Bezugszeichenliste

- 1: Satellit
- 2: Übertragungseinheit, Antenne
- 10: Hochfrequenzbaugruppe
- 18: Eingangsschnittstelle
- 20: Signalquelle
- 21: Verstärkereinheit
- 22: Halbleiter-Verstärkerausgang (Halbleiter, Transistor)
- 23: erste Leitung
- 24: zweite Leitung
- 25: Übertragungspfad (Leitung, Leiterbahn auf Platine)
- 26: kapazitives Kopplungselement
- 28: Grundplatte
- 29: Lücke, galvanische Trennung
- 30: Impedanzanpassungsfilter
- 31: erste Schnittstelle
- 32: Resonator
- 34: Fenster
- 36: Signalausbreitungsrichtung, Übertragungsrichtung
- 39: zweite Schnittstelle
- 40: Kopplungseinheit
- 50: Hochfrequenzwellenleiter (Hohlleiter, Stegholleiter, Koaxialleitung)
- 60: Leistungsquelle (DC-Energieversorgung)
- 61: DC-Filter
- 62: Anschlussleitung
- 71: Koppelschlitz
- 75: Abdeckung
- 80: Steg
- 80A, 80B, 80C: Stegabschnitt
- 100: Antennenanordnung

## Patentansprüche

1. Hochfrequenzbaugruppe, HF-Baugruppe, (10), aufweisend:
eine Signalquelle (20) aufweisend einen Halbleiter-Verstärkerausgang (22);
ein Impedanzanpassungsfilter (30) mit einer ersten Schnittstelle (31) und einer zweiten Schnittstelle (39); und
einen Hochfrequenzwellenleiter, HF-Wellenleiter, (50);
wobei die erste Schnittstelle (31) mittels einer oder mehrerer Leitungen (23, 24) und eines Übertragungspfads (25) der HF-Baugruppe (10) mit der Signalquelle (20) kommunikativ gekoppelt ist, um ein Hochfrequenzsignal, HF-Signal, von der Signalquelle (20) zu dem Impedanzanpassungsfilter (30) übertragen zu können;
wobei die zweite Schnittstelle (39) mit dem HF-Wellenleiter (50) kommunikativ gekoppelt ist, um ein HF-Signal von dem Impedanzanpassungsfilter (30) zu dem HF-Wellenleiter (50) übertragen zu können;
wobei ein erster Impedanzwert an der ersten Schnittstelle (31) einem Impedanzwert an dem Halbleiter-Verstärkerausgang (22) entspricht;
wobei ein zweiter Impedanzwert an der zweiten Schnittstelle (39) einem Impedanzwert an dem HF-Wellenleiter (50) entspricht;
wobei der erste Impedanzwert und der zweite Impedanzwert unterschiedliche Werte haben;
wobei die HF-Baugruppe weiterhin eine Grundplatte (28) aufweist;
wobei der Halbleiter-Verstärkerausgang (22) auf der Grundplatte (28) angeordnet ist; und **dadurch gekennzeichnet, dass** der Halbleiter-Verstärkerausgang (22) zur Gleichstrom-Energieversorgung über die eine oder die mehreren Leitungen (23, 24) mit dem Übertragungspfad (25) auf der Grundplatte (28) galvanisch gekoppelt ist;
wobei der Übertragungspfad (25) ein kapazitives Kopplungselement (26) aufweist, welches der ersten Schnittstelle (31) gegenüberliegt und angeordnet ist, hochfrequente Signale kapazitiv in die erste Schnittstelle (31) einzukoppeln;
wobei das kapazitive Kopplungselement (26) von der ersten Schnittstelle (31) galvanisch getrennt und durch eine Lücke (29) davon beabstandet ist.

2. HF-Baugruppe (10) nach Anspruch 1,
wobei der Halbleiter-Verstärkerausgang (22) einen niedrigeren Impedanzwert aufweist als der HF-Wellenleiter (50).

3. HF-Baugruppe (10) nach Anspruch 1 oder 2,
wobei das Impedanzanpassungsfilter (30) als Hohlleiter mit mindestens einem Resonator (32) und/oder mindestens einem Fenster (34) ausgestaltet ist.

4. HF-Baugruppe (10) nach Anspruch 3,
wobei das Impedanzanpassungsfilter (30) mehrere Resonatoren (32) und/oder mehrere Fenster (34) aufweist, die entlang einer Signalausbreitungsrichtung (36) in dem Impedanzanpassungsfilter (30) hintereinander angeordnet sind.

5. HF-Baugruppe (10) nach Anspruch 4,
wobei sich die mehreren entlang der Signalausbreitungsrichtung (36) hintereinander angeordneten Resonatoren (32) in ihrer Geometrie entlang der Signalausbreitungsrichtung (36) voneinander unterscheiden.

6. HF-Baugruppe (10) nach Anspruch 1 oder 2,
wobei das Impedanzanpassungsfilter (30) als Hohlleiter mit einem Steg (80) ausgestaltet ist.

7. HF-Baugruppe (10) nach Anspruch 6,
wobei der eine Steg (80) mehrere Stegabschnitte (80A, 80B, 80C) aufweist, welche unterschiedliche Geometrien aufweisen.

8. HF-Baugruppe (10) nach einem der voranstehenden Ansprüche,
weiterhin aufweisend eine Leistungsquelle (60), welche galvanisch mit dem Übertragungspfad (25) gekoppelt ist und ausgeführt ist, eine Energieversorgung in Form von Gleichstrom, DC, auf den Übertragungspfad zu geben und über die eine oder mehreren Leitungen (23, 24) an den Halbleiter-Verstärkerausgang bereitzustellen.

9. HF-Baugruppe (10) nach Anspruch 8,
wobei die Leistungsquelle (60) ein DC-Filter (61) aufweist, welches ausgestaltet ist, für hochfrequente Signale auf dem Übertragungspfad (25) undurchlässig zu sein.

10. HF-Baugruppe (10) nach einem der voranstehenden Ansprüche,
aufweisend eine Mehrzahl von Halbleiter-Verstärkerausgängen (22A, 22B, 22C, 22D), welche mit der ersten Schnittstelle (31) des Impedanzanpassungsfilters kapazitiv gekoppelt sind.

11. HF-Baugruppe (10) nach einem der voranstehenden Ansprüche,
aufweisend eine Mehrzahl von Impedanzanpassungsfiltern (30), wovon jedes mit mindestens einem Halbleiter-Verstärkerausgang (22) gekoppelt ist;
wobei die Mehrzahl von Impedanzanpassungsfiltern (30) mit einem einzelnen HF-Wellenleiter (50) gekoppelt sind.

12. HF-Baugruppe (10) nach einem der voranstehenden Ansprüche,
wobei der HF-Wellenleiter (50) ein Hohlleiter, ein Steghohlleiter, oder ein Koaxialleiter ist.

13. Antennenanordnung (100), aufweisend:
eine Antenne (2); und
eine Mehrzahl von HF-Baugruppen (10) nach einem der voranstehenden Ansprüche;
wobei die Mehrzahl von HF-Baugruppen (10) mit der Antenne verbunden sind, um ein Nutzsignal an die Antenne zu übertragen.

14. Kommunikationssatellit (1), aufweisend eine Antennenanordnung (100) nach Anspruch 13.

## Claims

1. Radio-frequency assembly, RF assembly, (10), having:
a signal source (20) having a semiconductor amplifier output (22);
an impedance matching filter (30) with a first interface (31) and a second interface (39); and
a radio-frequency waveguide, RF waveguide, (50);
wherein the first interface (31) is communicatively coupled to the signal source (20) by means of one or more lines (23, 24) and a transmission path (25) of the RF assembly (10) in order to be able to transmit a radio-frequency signal, RF signal, from the signal source (20) to the impedance matching filter (30);
wherein the second interface (39) is communicatively coupled to the RF waveguide (50) in order to be able to transmit an RF signal from the impedance matching filter (30) to the RF waveguide (50);
wherein a first impedance value at the first interface (31) corresponds to an impedance value at the semiconductor amplifier output (22);
wherein a second impedance value at the second interface (39) corresponds to an impedance value at the RF waveguide (50);
wherein the first impedance value and the second impedance value have different values;
wherein the RF assembly furthermore has a baseplate (28);
wherein the semiconductor amplifier output (22) is arranged on the baseplate (28) ; and **characterized in that** the semiconductor amplifier output (22), for the purpose of direct-current energy supply, is galvanically coupled via said one or more lines (23, 24) to the transmission path (25) on the baseplate (28);
wherein the transmission path (25) has a capacitive coupling element (26) situated opposite the first interface (31) and arranged for capacitively coupling radio-frequency signals into the first interface (31);
wherein the capacitive coupling element (26) is galvanically isolated from the first interface (31) and spaced apart therefrom by a gap (29).

2. RF assembly (10) according to Claim 1,
wherein the semiconductor amplifier output (22) has a lower impedance value than the RF waveguide (50).

3. RF assembly (10) according to Claim 1 or 2,
wherein the impedance matching filter (30) is configured as a hollow waveguide with at least one resonator (32) and/or at least one window (34).

4. RF assembly (10) according to Claim 3,
wherein the impedance matching filter (30) has a plurality of resonators (32) and/or a plurality of windows (34) which are arranged one behind another along a signal propagation direction (36) in the impedance matching filter (30).

5. RF assembly (10) according to Claim 4,
wherein the plurality of resonators (32) arranged one behind another along the signal propagation direction (36) differ from one another in terms of their geometry along the signal propagation direction (36).

6. RF assembly (10) according to Claim 1 or 2,
wherein the impedance matching filter (30) is configured as a hollow waveguide with one ridge (80).

7. RF assembly (10) according to Claim 6,
wherein said one ridge (80) has a plurality of ridge sections (80A, 80B, 80C) having different geometries.

8. RF assembly (10) according to any of the preceding claims,
furthermore having a power source (60), which is galvanically coupled to the transmission path (25) and is embodied for passing an energy supply in the form of direct current, DC, onto the transmission path and providing it via said one or more lines (23, 24) to the semiconductor amplifier output.

9. RF assembly (10) according to Claim 8,
wherein the power source (60) has a DC filter (61) configured to be non-transmissive for radio-frequency signals on the transmission path (25).

10. RF assembly (10) according to any of the preceding claims,
having a plurality of semiconductor amplifier outputs (22A, 22B, 22C, 22D) capacitively coupled to the first interface (31) of the impedance matching filter.

11. RF assembly (10) according to any of the preceding claims,
having a plurality of impedance matching filters (30), each of which is coupled to at least one semiconductor amplifier output (22);
wherein the plurality of impedance matching filters (30) are coupled to a single RF waveguide (50).

12. RF assembly (10) according to any of the preceding claims,
wherein the RF waveguide (50) is a hollow waveguide, a ridge hollow waveguide, or a coaxial conductor.

13. Antenna arrangement (100), having:
an antenna (2); and
a plurality of RF assemblies (10) according to any of the preceding claims;
wherein the plurality of RF assemblies (10) are connected to the antenna in order to transmit a useful signal to the antenna.

14. Communication satellite (1), having an antenna arrangement (100) according to Claim 13.

## Revendications

1. Module haute fréquence, module HF, (10), présentant :
une source de signal (20) présentant une sortie d'amplificateur à semi-conducteur (22) ;
un filtre d'adaptation d'impédance (30) pourvu d'une première interface (31) et d'une deuxième interface (39) ; et
un guide d'ondes haute fréquence, guide d'ondes HF, (50) ;
dans lequel la première interface (31) est couplée en communication au moyen d'une ou de plusieurs lignes (23, 24) et d'un chemin de transmission (25) du module HF (10) à la source de signal (20) afin de pouvoir transmettre un signal haute fréquence, signal HF, de la source de signal (20) au filtre d'adaptation d'impédance (30) ;
dans lequel la deuxième interface (39) est couplée en communication au guide d'ondes HF (50) afin de pouvoir transmettre un signal HF du filtre d'adaptation d'impédance (30) au guide d'ondes HF (50) ;
dans lequel une première valeur d'impédance au niveau de la première interface (31) correspond à une valeur d'impédance au niveau de la sortie d'amplificateur à semi-conducteur (22) ;
dans lequel une deuxième valeur d'impédance au niveau de la deuxième interface (39) correspond à une valeur d'impédance au niveau du guide d'ondes HF (50) ;
dans lequel la première valeur d'impédance et la deuxième valeur d'impédance présentent des valeurs différentes ; dans lequel le module HF présente en outre une plaque de base (28) ;
dans lequel la sortie d'amplificateur à semi-conducteur (22) est disposée sur la plaque de base (28) ; et **caractérisé en ce que** la sortie d'amplificateur à semi-conducteur (22) est couplée galvaniquement au chemin de transmission (25) sur la plaque de base (28) pour l'alimentation en énergie de courant continu par ladite une ou les plusieurs lignes (23, 24) ;
dans lequel le chemin de transmission (25) présente un élément de couplage capacitif (26) qui se trouve à l'opposé de la première interface (31) et est disposé pour injecter de manière capacitive des signaux haut fréquence dans la première interface (31) ;
dans lequel l'élément de couplage capacitif (26) est séparé galvaniquement de la première interface (31) et espacé de celle-ci par un entrefer (29).

2. Module HF (10) selon la revendication 1,
dans lequel la sortie d'amplificateur à semi-conducteur (22) présente une valeur d'impédance inférieure à celle du guide d'ondes HF (50).

3. Module HF (10) selon la revendication 1 ou 2,
dans lequel le filtre d'adaptation d'impédance (30) est configuré en tant que guide d'ondes creux pourvu d'au moins un résonateur (32) et/ou d'au moins une fenêtre (34) .

4. Module HF (10) selon la revendication 3,
dans lequel le filtre d'adaptation d'impédance (30) présente plusieurs résonateurs (32) et/ou plusieurs fenêtres (34) qui sont disposés les uns après les autres le long d'une direction de propagation de signal (36) dans le filtre d'adaptation d'impédance (30).

5. Module HF (10) selon la revendication 4,
dans lequel les résonateurs (32) disposés les uns après les autres le long de la direction de propagation de signal (36) se distinguent entre eux par leur géométrie le long de la direction de propagation de signal (36).

6. Module HF (10) selon la revendication 1 ou 2,
dans lequel le filtre d'adaptation d'impédance (30) est configuré en tant que guide d'ondes creux avec une moulure (80).

7. Module HF (10) selon la revendication 6,
dans lequel ladite une moulure (80) présente plusieurs sections de moulure (80A, 80B, 80C) qui présentent différentes géométries.

8. Module HF (10) selon l'une quelconque des revendications précédentes,
présentant en outre une source de puissance (60) qui est couplée galvaniquement au chemin de transmission (25) et est réalisée pour mettre une alimentation en énergie sous forme de courant continu, DC, sur le chemin de transmission et pour la fournir par ladite une ou les plusieurs lignes (23, 24) à la sortie d'amplificateur à semi-conducteur.

9. Module HF (10) selon la revendication 8,
dans lequel la source de puissance (60) présente un filtre DC (61) qui est configuré pour ne pas laisser passer des signaux haute fréquence sur le chemin de transmission (25).

10. Module HF (10) selon l'une quelconque des revendications précédentes,
présentant une pluralité de sorties d'amplificateur à semi-conducteur (22A, 22B, 22C, 22D) qui sont couplées de manière capacitive à la première interface (31) du filtre d'adaptation d'impédance.

11. Module HF (10) selon l'une quelconque des revendications précédentes,
présentant une pluralité de filtres d'adaptation d'impédance (30) dont chacun est couplé à au moins une sortie d'amplificateur à semi-conducteur (22) ;
dans lequel la pluralité de filtres d'adaptation d'impédance (30) est couplée à un guide d'ondes HF (50) unique.

12. Module HF (10) selon l'une quelconque des revendications précédentes,
dans lequel le guide d'ondes HF (50) est un guide d'ondes creux, un guide d'ondes creux à moulure ou un guide d'ondes coaxial.

13. Ensemble d'antenne (100), présentant :
une antenne (2) ; et
une pluralité de modules HF (10) selon l'une quelconque des revendications précédentes ;
dans lequel la pluralité de modules HF (10) est reliée à l'antenne pour transmettre un signal utile à l'antenne.

14. Satellite de communication (1), présentant un ensemble d'antenne (100) selon la revendication 13.
